# EUROPÄISCHE PATENTANMELDUNG

(11) **EP 0 695 932 A1**
(43) Veröffentlichungstag der Anmeldung: **07.02.1996**
(21) Anmeldenummer: 95106036.7
(22) Anmeldetag: 22.04.1995
(51) Int. Cl.: G01J 5/12, H01L 35/08

(54) **Thermoelektrisches Bauelement**

(30) Priorität: 03.08.1994 DE 4428844
(71) Anmelder: HL PLANARTECHNIK GMBH, D-44227 Dortmund (DE)
(72) Erfinder: Hedler,Harry,Dr.Dipl.-Phys., D-81377 München (DE); Winterfeldt,Joachim,Dipl.-Ing., D-58239 Schwerte (DE); Herrnsdorf,Johannes,Dipl.-Phys., D-58313 Herdecke (DE); Lilienhof,Hans-Joachim,Dr.Dipl.-Phys., D-44532 Lünen (DE)
(74) Vertreter: Patentanwälte Gesthuysen, von Rohr & Weidener

(57) **Zusammenfassung**

Gegenstand der Erfindung ist ein thermoelektrisches Bauelement, insbesondere für infrarote und sichtbare Strahlung, mit einem, vorzugsweise hermetisch geschlossenen und einen Sensorinnenraum mit einer definierten Gasfüllung bildenden, Gehäuse (1) mit einer Öffnung (2), die vorzugsweise durch ein für die Strahlung durchlässiges Eintrittsfenster (3) abgedeckt ist, mit einem im Gehäuse (1) angeordneten Sensorträger (4) mit einem darauf angeordneten Strahlungsbauelement (8), wobei das Strahlungsbauelement (8) eine aktive Oberfläche aufweist, und mit aus dem Gehäuse (1) herausgeführten elektrischen Anschlußleitungen (11,12) für das Strahlungsbauelement (8), das dadurch gekennzeichnet ist, daß im Gehäuse (1) mit Abstand vom Eintrittsfenster (3) bzw. von der Öffnung ein Strahlungs-Kollektorelement (9) in Form eines Spiegels (oder eines Spiegelsystems) angeordnet ist oder die Innenseite der Wandung des Gehäuses (1) ein solches Kollektorelement (9) bildet und daß die aktive Oberfläche vom Eintrittsfenster (3) bzw. der Öffnung weg zum Kollektorelement (9) gerichtet ist. Gegenstand ist auch ein Bauelement, bei dem das Strahlungsbauelement mindestens zwei, vorzugsweise mehrere voneinander unabhängige Strahlungsempfänger aufweist, deren aktive Oberfläche in einer Ebene nebeneinander angeordnet sind.

## Beschreibung

Die Erfindung betrifft ein thermoelektrisches Bauelement, insbesondere für infrarote und sichtbare Strahlung, mit den Merkmalen des Oberbegriffes von Anspruch 1. Ein solches thermoelektrisches Bauelement kann ein Strahlungsempfängerelement oder ein Strahlungssenderelement sein.

Thermoelektrische Bauelemente der in Rede stehenden Art sind seit längerem bekannt. Ein übliches als Strahlungsempfänger ausgeführtes thermoelektrisches Bauelement (Measurement Vol 6 No 1, Jan-Mar 1988, Seiten 2 bis 4) weist zunächst ein Gehäuse auf, das einen geschlossenen Sensorinnenraum bildet. In diesem befindet sich eine definierte Gasfüllung, entweder trockenes Schutzgas wie Argon, Krypton, Xenon oder Stickstoff, oder nach Evakuierung auf einen bestimmten geringen Druck verbleibende Restluft. Das Gehäuse ist hermetisch geschlossen, beispielsweise verschweißt oder geklebt, so daß sich an der Gasfüllung im Sensorinnenraum im Betrieb nichts ändert. Diese Gasfüllung ist für die definierte Sensor-Charakteristik von erheblicher Bedeutung, insbesondere weil sehr kleine Energieströme der Wärmestrahlung erfaßt werden müssen.

Ein solches thermoelektrisches Bauelement ist also ein voll gekapseltes Element. Im Inneren befindet sich ein Sensorträger aus einem umlaufenden Rahmen mit elektrischen Anschlüssen, eine im Rahmen aufgespannte dünne Trägermembran und auf der Trägermembran ein elektrisch nach außen mit den Anschlüssen verbundener Dünnschicht-Strahlungsaufnehmer als Strahlungsbauelement. Die Fläche des Strahlungsaufnehmers ist wesentlich kleiner als die Fläche des Eintrittsfensters im Gehäuse.

Das bekannte thermoelektrische Bauelement, von dem die Erfindung ausgeht, arbeitet mit einer Mehrzahl von in Reihe geschalteten Thermoelementen, die gemeinsam das Strahlungsbauelement bilden. Diese Thermoelemente sind sternförmig auf die Mitte der Trägermembran zulaufend angeordnet. Die Meßstellen befinden sich unter einer als Absorptionsschicht ausgeführten Abdeckschicht in der Mitte der Trägermembran, die Vergleichsstellen der Thermoelemente befinden sich auf dem als Wärmesenke dienenden Rahmen. Die durch die Öffnung im Gehäuse und das darin meist befindliche Eintrittsfenster eintretende Strahlung, meist Infrarotstrahlung, wird in der Absorptionsschicht in Wärme umgewandelt, die die Meßstellen der Thermoelemente beeinflußt und so eine elektrische Messung der eintretenden Strahlung erlaubt.

Bei einem anderen aus der Praxis bekannten thermoelektrischen Strahlungssensor wird nach dem Prinzip eines Bolometers mit einer Platinfolie mit einer Schwärzung auf der Oberfläche der Absorptionsschicht gearbeitet bzw. mit Halbleiter-Thermistoren auf einer entsprechend dünnen Trägermembran.

Eine dünne Trägermembran läßt sich beispielsweise in einem Rahmen aus Silizium durch mikromechanische Ätzung von der Rückseite her herstellen, sie besteht häufig aus Silizium-Oxid-Nitrid, das bei der Ätzung von Silizium nicht angegriffen wird.

Ein besonderes Einsatzgebiet solcher thermoelektrischer Strahlungssensoren sind Strahlungspyrometer (siehe z. B. die US - A - 4,347,418). Bei dem hier angesprochenen Beispiel befindet sich ein voll gekapselter Strahlungssensor im Brennpunkt einer Parabol-Spiegeloptik. Die Parabol-Spiegeloptik wird durch den Trage-Steg für den Strahlungssensor und den im Durchmesser etwa 10 mm betragenden Strahlungssensor selbst in großen Bereichen abgedeckt. Der Durchmesser des Parabolspiegels muß also relativ groß sein. Außerdem ist diese offene Optik verschmutzungsempfindlich. Wegen der Positionierung des Strahlungssensors vor dem Parabolspiegel läßt sich das Spiegelsystem auch nur schwierig reinigen. Gleichwohl wird bislang bei allen bekannten Konstruktionen der gekapselte Strahlungssensor entweder unmittelbar oder in dieser Weise mit einer externen Optik in Verbindung eingesetzt.

Bei den üblichen thermoelektrischen Strahlungssensoren ist die Meßempfindlichkeit vom Verhältnis der Fläche der Absorptionsschicht (Abdeckschicht) zur Fläche des Eintrittsfensters abhängig. Nur die Anteile der Strahlung, die von der Strahlungsquelle durch das Eintrittsfenster des Gehäuses direkt auf den Strahlungsaufnehmer treffen, führen zu einem auswertbaren Signal. Der überwiegende Anteil der Strahlung trifft außerhalb des Strahlungsaufnehmers auf Trägermembran, Rahmen und Gehäuseteile und führt nicht zur Erwärmung der Absorptionsschicht und damit nicht zu einem Meßsignal. Im Gegenteil, es kann sich sogar eine Erwärmung der Wärmesenke am Rahmen ergeben, die das vorhandene Meßsignal beeinträchtigt. Der Ausnutzungsgrad beträgt häufig nur 2 bis 5 % der insgesamt einfallenden Strahlung.

Man könnte den Ausnutzungsgrad dadurch erhöhen, daß man die lateralen Abmessungen, insbesondere den Durchmesser, der Absorptionsschicht und die Dicke der Absorptionsschicht erhöht. Damit wird dann zwar der Ausnutzungsgrad erhöht, gleichzeitig wird der Strahlungssensor aber träger, da die Wärmekapazität der Absorptionsschicht entsprechend ansteigt. Außerdem ist eine Vergrößerung der lateralen Abmessung auch deshalb nur begrenzt möglich, weil bei Einsatz von Thermoelementen im Strahlungsaufnehmer der laterale Abstand zwischen den konzentriert in der Mitte der Trägermembran angeordneten Meßstellen der Thermoelemente und dem Rand der als Absorptionsschicht ausgeführten Abdeckschicht nicht zu groß werden darf.

Schließlich läßt der Aufbau eine Einschränkung des nutzbaren Öffnungswinkelbereiches unmittelbar nur durch Verkleinerung des Eintrittsfensters zu. Strahlungsempfänger mit Öffnungswinkeln von beispielsweise weniger als 10° sind damit praktisch nicht realisierbar.

Abhilfe hinsichtlich des Ausnutzungsgrads und/oder hinsichtlich des Öffnungswinkels läßt sich lediglich durch die zuvor angegebenen äußeren optischen Einrichtungen schaffen, was dann zu den ebenfalls zuvor erläuterten Problemen führt.

Es besteht also das Problem, ein thermoelektrisches Bauelement der in Rede stehenden Art insbesondere für infrarote und sichtbare Strahlung anzugeben, bei dem sich eine wesentlich höhere Empfindlichkeit bei möglichst geringer Trägheit und insbesondere für geringe Öffnungswinkelbereiche ergibt.

Im Grundsatz löst das erfindungsgemäße thermoelektrische Bauelement das zuvor angegebene Problem mit den Merkmalen des kennzeichnenden Teils von Anspruch 1. Erfindungsgemäß wird also eine wirksame optische Anordnung in das Gehäuse integriert, sie ist somit Teil des Sensorinnenraumes. Die einzelnen Bestandteile eines solchen Strahlungssensors werden erfindungsgemäß doppelt genutzt, insbesondere gilt das für das Gehäuse, dessen Wandung gleichzeitig das Kollektorelement bildet. Bei geschlossenem Eintrittsfenster profitiert die Optik von der definierten, durch das geschlossene Gehäuse sich nicht ändernden Atmosphäre im Sensorinnenraum. Eine Verschmutzung der Optik entfällt, die Baugröße des Kollektorelements ist auf das absolute Minimum beschränkt.

Gerade für einen kleinen Öffnungswinkelbereich des Eintrittsfensters, also einer sich der Erfassung von Parallelstrahlung nähernden Charakteristik des thermoelektrischen Bauelements, wirkt das in Strahlungseinfallsrichtung "hinter" dem Strahlungsbauelement angeordnete Strahlungs-Kollektorelement in Form eines Spiegels außerordentlich wirksam. Dabei ist es wesentlich preiswerter als eine "vor" der aktiven Oberfläche des Strahlungsbauelementes angeordnete IR-Sammellinse. Im IR-Bereich hochdurchlässige Linsenwirkstoffe sind nämlich nach wie vor ausgesprochen teuer. Die tatsächliche aktive Oberfläche des Strahlungsbauelementes kann sehr klein werden. Das Verhältnis der durch das Eintrittsfenster des Gehäuses dargestellten virtuellen Empfängerfläche zu der physischen Empfängerfläche - aktive Oberfläche des Strahlungsbauelementes - kann bei dem Faktor 1000 oder darüber liegen. Entsprechendes gilt für eine Gestaltung des Strahlungsbauelementes als Strahlungselement, für die natürlich ganz entsprechende Überlegungen gelten. Wegen des zuvor angesprochenen großen Verhältnisses der beiden genannten Empfängerflächen zueinander wird bei dem erfindungsgemäß mit integrierter Optik versehenen Gehäuse der Strahlengang durch das Strahlungsbauelement selbst nur wenig abgeschattet.

Es liegt auf der Hand, daß das Strahlungs-Kollektorelement für den in Frage kommenden Wellenlängenbereich, insbesondere den Infrarotbereich, einen möglichst hohen Reflexionsgrad aufweisen sollte. Dies löst gleichzeitig ein besonderes Problem eines als Strahlungsempfängerelement ausgeführten Strahlungsbauelementes. Bekanntlich sind Strahlungsempfängerelemente im Infrarotbereich besonders empfindlich gegenüber Wärmestrahlung von Gehäusewänden. Da jedoch das Strahlungsempfängerelement mit seiner aktiven Oberfläche nunmehr erfindungsgemäß in das hoch reflektierende Kollektorelement hinein "gerichtet" ist, wird dadurch das übrige Gehäuse des thermoelektrischen Bauelementes hinsichtlich des Strahlungsempfängerelementes praktisch komplett abgeschirmt. Entsprechend, wenn auch von weniger einschneidender Bedeutung, wirkt auch Fremdstrahlung bei Gestaltung des thermoelektrischen Bauelementes mit einem Strahlungssenderelement weniger störend.

Besondere Bedeutung kommt auch dem - nebengeordneten - Patentanspruch 30 zu. Erfindungsgemäß ist erkannt worden, daß man mit der Anordnung von mindestens zwei, vorzugsweise jedoch von mehreren voneinander unabhängigen Strahlungsempfängern mit ihren aktiven Oberflächen in einer Ebene nebeneinander insbesondere in Verbindung mit einem als Spiegel ausgeführten Strahlungs-Kollektorelement, durchaus aber auch in Verbindung mit einer Sammellinse od. dgl., zu einer miniaturisierten Anordnung eines Spektrometers, insbesondere eines Infrarotspektrometers gelangen kann.

Bevorzugte Ausgestaltungen und Weiterbildungen der Erfindung sind in den übrigen Ansprüchen beschreiben.

Im folgenden wird die Erfindung anhand einer lediglich verschiedene Ausführungsbeispiele darstellenden Zeichnung näher erläutert. In der Zeichnung zeigt
- Fig. 1: im Schnitt ein erstes Ausführungsbeispiel eines thermoelektrischen Bauelementes in der Ausführung mit einem Strahlungsempfängerelement, in einer Prinzipdarstellung,
- Fig. 2: in einer Ansicht die Innenseite des Eintrittsfensters des Bauelements aus Fig. 1,
- Fig. 3: in einer Fig. 1 entsprechenden Darstellung ein weiteres Ausführungsbeispiel eines erfindungsgemäßen thermoelektrischen Bauelementes mit einem Strahlungsempfängerelement,
- Fig. 4: in einer Fig. 2 entsprechenden Ansicht die Innenseite des Eintrittsfensters, jedoch jetzt ohne das Strahlungsbauelement,
- Fig. 5: in einer Fig. 1 entsprechenden Darstellung ein drittes Ausführungsbeispiel eines erfindungsgemäßen thermoelektrischen Bauelementes,
- Fig. 6: in einer Fig. 1 entsprechenden Darstellung ein viertes Ausführungsbeispiel eines erfindungsgemäßen thermoelektrischen Bauelementes, hier mit einem als Strahlungssenderelement ausgeführten Strahlungsbauelement,
- Fig. 7: in einer Fig. 6 entsprechenden Darstellung ein weiteres Ausführungsbeispiel eines thermoelektrischen Bauelementes mit einem Strahlungssenderelement,
- Fig. 8: in einer perspektivischen Darstellung einen Sensorträger mit einem darauf angeordneten Strahlungsbauelement mit einer Mehrzahl von nebeneinander angeordneten Strahlungsempfängern,
- Fig. 9: die Anordnung aus Fig. 8, eingebaut in einem thermoelektrischen Bauelement in Form eines Infrarotspektrometers, in einer Prinzipdarstellung,
- Fig. 10: in einer Fig. 1 ähnlichen Darstellung ein weiteres Ausführungsbeispiel eines erfindungsgemäßen thermoelektrischen Bauelementes, hier mit einem Lichtwellenleiter zur Einspeisung,
- Fig. 11: in einer Fig. 1 ähnlichen Darstellung ein weiteres Ausführungsbeispiel eines erfindungsgemäßen thermoelektrischen Bauelementes,
- Fig. 12: die Halterung des Ausführungsbeispiels aus Fig. 11 in einer Draufsicht und
- Fig. 13: eine Meßstrecke mit zwei erfindungsgemäßen thermoelektrischen Bauelementen.

Gegenstand der Erfindung ist ein thermoelektrisches Bauelement, das insbesondere für infrarote und sichtbare Strahlung, ganz besonders für infrarotes Licht bestimmt und geeignet ist. Die Erfindung betrifft dabei sowohl als Empfänger arbeitende thermoelektrische Bauelemente als auch als Sender arbeitende thermoelektrische Bauelemente. Die als Empfänger arbeitenden thermoelektrischen Bauelemente finden beispielsweise in Strahlungspyrometern umfangreiche Anwendung.

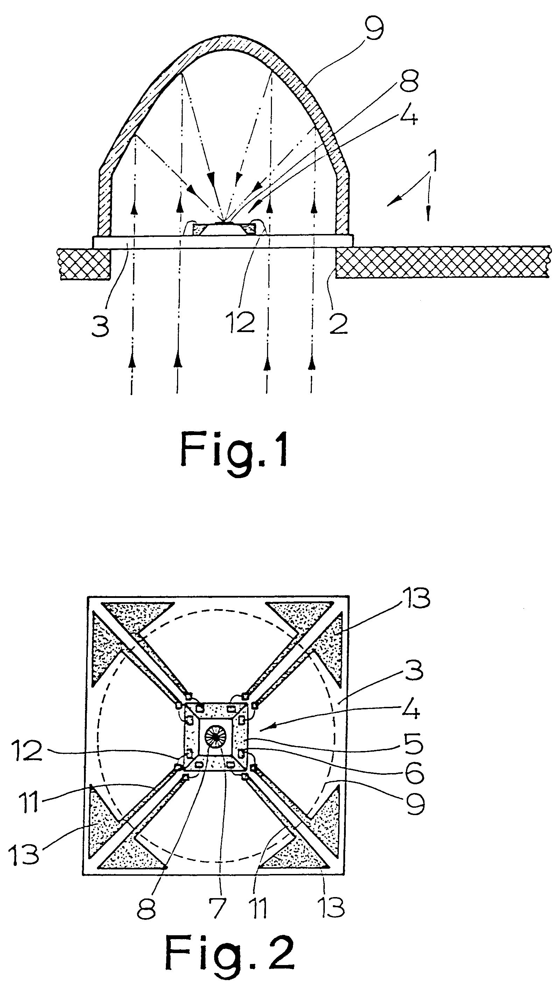

Aus einer Zusammenschau von Fig. 1 und 2 erkennt man am dort dargestellten Ausführungsbeispiel eines thermoelektrischen Strahlungsempfängers zunächst ein Gehäuse 1 mit einer Öffnung 2, die im vorliegenden Ausführungsbeispiel durch ein für die Strahlung durchlässiges Eintrittsfenster 3 abgedeckt ist. Das Gehäuse 1 könnte im Prinzip auch offen sein, das würde aber eine Verschmutzungsempfindlichkeit ergeben. Wie für solche thermoelektrischen Bauelemente bevorzugt ist das Gehäuse 1 hermetisch geschlossen und bildet so einen Sensorinnenraum mit einer definierten Gasfüllung (trockenes Schutzgas oder Restluftfüllung nach vorheriger Evakuierung), was die Sensor-Empfindlichkeit positiv beeinflußt.

Im Gehäuse 1 angeordnet ist ein Sensorträger 4. Wie in den Fig. 1 und 2 lediglich angedeutet ist, besteht der Sensorträger 4 aus einem umlaufenden Rahmen 5 mit elektrischen Anschlüssen 6, einer im Rahmen 5 aufgespannten dünnen Trägermembran 7 und auf der Trägermembran 7 einem elektrisch nach außen mit den Anschlüssen 6 verbundenen Dünnschicht-Strahlungsbauelement 8. Dies läßt sich in Fig. 2 andeutungsweise erkennen. Ist das Strahlungsbauelement 8 als Strahlungsempfängerelement ausgeführt, so kann es mit einer Absorptionsschicht versehen sein. Im übrigen darf auf die Ausführungen zum Stand der Technik bei der Einleitung des allgemeinen Teils der Beschreibung verwiesen werden. Auch im vorliegenden Fall kann mit einer Mehrzahl von in Reihe geschalteten Thermoelementen entsprechend der dort geschilderten Konstruktion gearbeitet werden.

Fig. 1 macht nun deutlich, wie Strahlung in das Eintrittsfenster 3 im Gehäuse 1 eintritt, wenn man einen relativ kleinen Öffnungswinkel voraussetzt. Hier ist die Strahlung als Parallelstrahlung angedeutet. Ohne besondere Maßnahmen würde nur ein sehr geringer Teil der über das Eintrittsfenster 3 in das Gehäuse 1 eintretenden Strahlung auf die aktive Oberfläche des Strahlungsbauelementes 8 treffen. Erfindungsgemäß ist nun jedoch vorgesehen, daß im Gehäuse 1 mit Abstand vom Eintrittsfenster 3 ein Strahlungs-Kollektorelement 9 in Form eines Spiegels (oder eines Spiegelsystems) angeordnet ist. Die aktive Oberfläche des Strahlungsbauelementes 8 ist vom Eintrittsfenster 3 weg zum Kollektorelement 9 hin gerichtet. Ebenso wie das Kollektorelement 9 im Gehäuse 1 im dargestellten und bevorzugten Ausführungsbeispiel mittig ausgerichtet ist, ist auch die aktive Oberfläche des Strahlungsbauelementes 8 mittig zum Kollektorelement 9 ausgerichtet, jedenfalls im hier dargestellten bevorzugten Ausführungsbeispiel. Es liegt auf der Hand, daß das Kollektorelement 9 so gestaltet ist, daß es für den in Frage kommenden Wellenlängenbereich der Strahlung, insbesondere also für den Infrarotbereich, einen möglichst hohen Reflexionsgrad aufweist. Das Strahlungselement 8 ist hier nicht im Gehäuse 1, sondern nahe an dem oder unmittelbar an dem Eintrittsfenster 3 angeordnet.

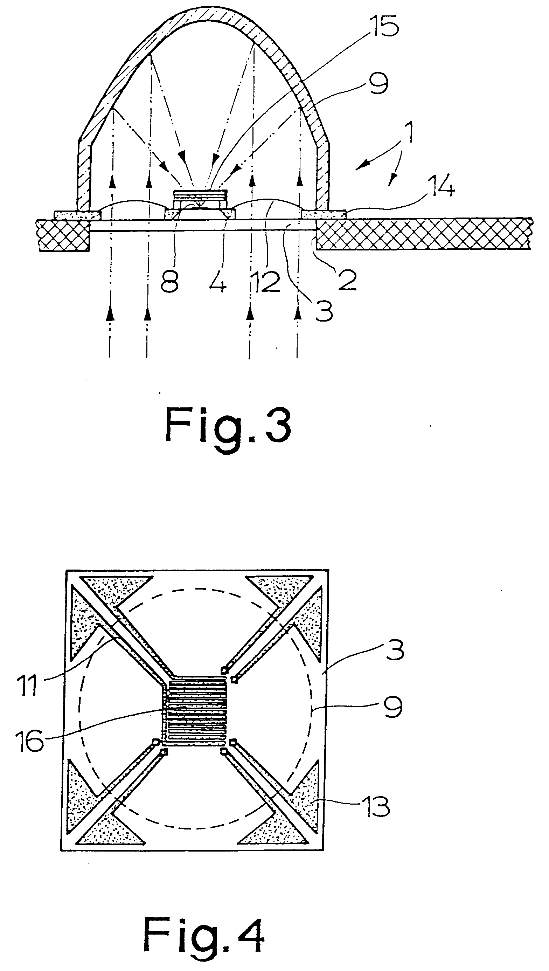

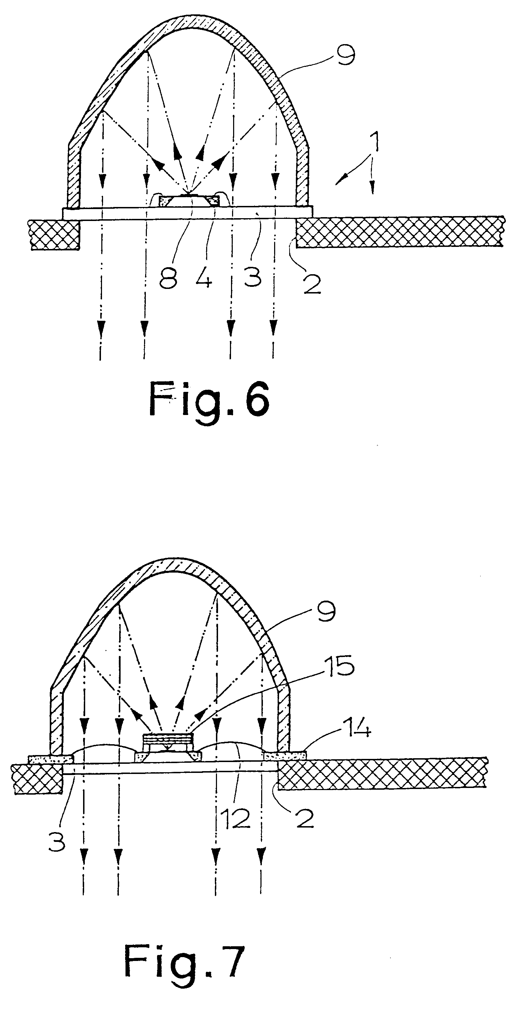

Im in Fig. 1 (und in Fig. 3) dargestellten Ausführungsbeispiel eines thermoelektrischen Strahlungsempfängers gilt, daß das Strahlungsbauelement 8 als Strahlungsempfängerelement ausgeführt ist und das Kollektorelement 9 die in einem bestimmten Öffnungswinkelbereich des Eintrittsfensters 3 eintretende Strahlung auf die aktive Oberfläche des Strahlungsbauelementes 8 konzentriert. Demgegenüber gilt in den in den Fig. 6 und 7 gezeigten Ausführungsbeispielen eines thermoelektrischen Strahlungssenders, daß das Strahlungsbauelement 8 als Strahlungssenderelement ausgeführt ist und das Kollektorelement 9 die von der aktiven Oberfläche des Strahlungsbauelementes 8 abgestrahlte Strahlung zum Eintrittsfenster 3 hin umlenkt, so daß diese in einem bestimmten Öffnungswinkelbereich aus dem Eintrittsfenster 3 austritt.

Ein Strahlungssenderelement ist häufig ein durch Stromfluß erwärmter Dünnschichtwiderstand, wie das an sich aus dem Stand der Technik bekannt ist.

Für die nachfolgenden Erläuterungen ist es ganz überwiegend von untergeordneter Bedeutung, ob es sich beim Strahlungsbauelement 8 um ein Strahlungsempfängerelement oder ein Strahlungssenderelement handelt. Dies wird daher nicht jeweils wieder differenziert. Lediglich dort, wo es auf diesen Unterschied ankommt, soll darauf jeweils hingewiesen werden.

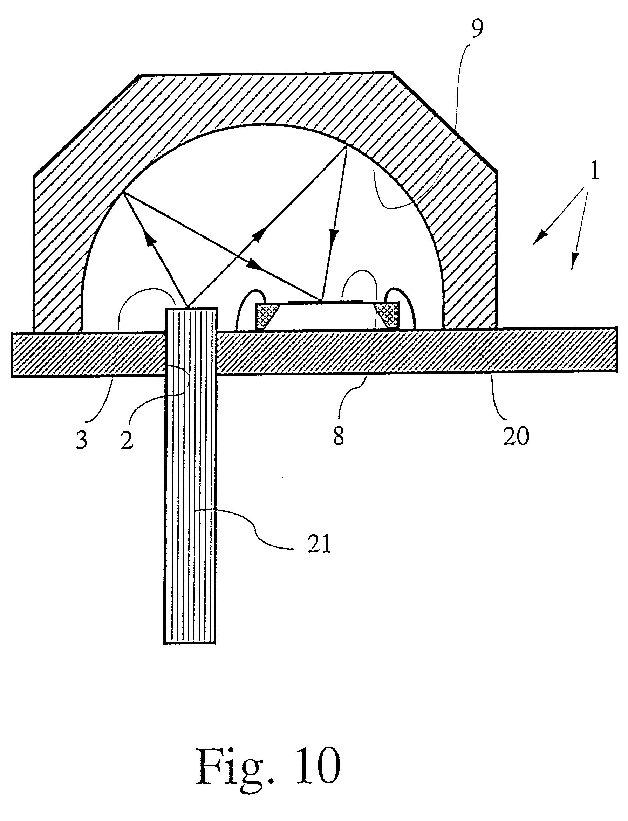

Zunächst ergibt sich aus Fig. 1 (und aus anderen Figuren), daß im dargestellten und insoweit bevorzugten Ausführungsbeispiel die Innenseite der Wandung des Gehäuses 1 das Kollektorelement 9 selbst bildet. Es ist also das Kollektorelement 9 nicht als zusätzliches Bauteil vorhanden, sondern hier gemäß bevorzugter Lehre integraler Bestandteil der Wandung des Gehäuses 1 gegenüber dem Eintrittsfenster 3. Weiter ergibt sich aus Fig. 1, daß das Kollektorelement 9 als sphärischer Spiegel ausgeführt ist. Im dargestellten und insoweit bevorzugten Ausführungsbeispiel hat das Kollektorelement 9 die Kontur eines Kegelschnittes, ist nämlich hier als Parabolspiegel ausgeführt. Das Strahlungsbauelement 8 liegt im wesentlichen in der Brennebene des Spiegels. Das entspricht der Zielrichtung der Erfindung auf einen kleinen Öffnungswinkelbereich der Gesamtanordnung. Kegelschnitte sind im übrigen noch Hyperbel, Ellipse, Kreis, siehe dazu auch Fig. 10.

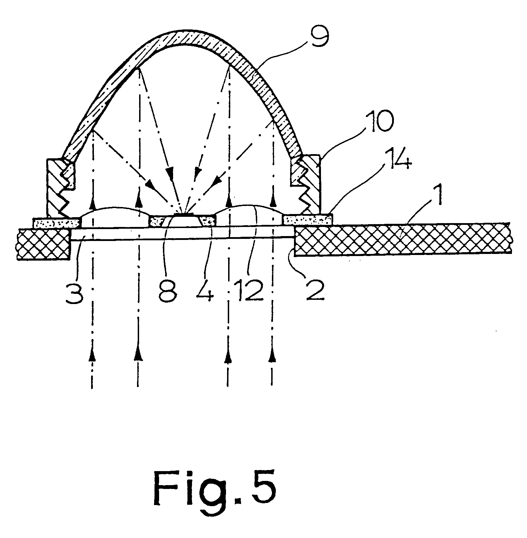

Wie die Figuren zeigen, befindet sich zur Begrenzung des Öffnungswinkelbereiches zwischen dem Kollektorelement 9 und dem Eintrittsfenster 3 ein gerader Abschnitt der Wandung des Gehäuses 1. Je länger dieser gerade Abschnitt ist, desto kleiner ist der Öffnungswinkelbereich, da seitlich eintretendes Streulicht nicht auf das Strahlungsbauelement reflektiert wird. In Fig. 5 ist eine darüber hinaus besondere Konstruktion gezeigt, die die Möglichkeit hat, daß das Kollektorelement 9 relativ zum Strahlungsbauelement 8, insbesondere in Richtung des Strahlungsverlaufs am Eintrittsfenster 3, verstellbar ist und so der genutzte Öffnungswinkelbereich einstellbar ist. Diese Verstellbarkeit ist hier durch eine Schraubfassung 10 realisiert, in die mit einem entsprechenden Außengewinde das Kollektorelement 9 in Richtung des Strahlungsverlaufes verstellbar ist. Somit ist der Kollimationswinkel einstellbar.

Das in den Fig. 1 und 2 dargestellte Ausführungsbeispiel zeigt, daß hier der Sensorträger 4 mit dem Strahlungsbauelement 8 auf dem Eintrittsfenster 3 angebracht ist und die elektrischen Anschlußleitungen für das Strahlungsbauelement 8 als Leiterbahnen 11 auf dem Eintrittsfenster 3 und/oder als dünne Anschlußdrähte 12 (Bonddrähte) ausgeführt sind. Fig. 2 zeigt in Verbindung mit Fig. 1, daß zunächst die Anschlußdrähte 12 von den Anschlüssen 6 auf dem Rahmen 5 auf Anschlußpads der Leiterbahnen 11 heruntergeführt sind. Diese Leiterbahnen 11 auf dem Eintrittsfenster 3 sind dann zu äußeren Anschlußflächen 13 auf dem Eintrittsfenster 3 geführt. Gestrichelt dargestellt ist die Umrißlinie des Kollektorelements 9, das hier ja von der Wandung des Gehäuses 1 gebildet ist, unter dessen Rand die Leiterbahnen 11 zu den äußeren Anschlußflächen 13 herausgeführt sind.

Auch beim Ausführungsbeispiel gemäß Fig. 3 ist der Sensorträger 4 direkt auf dem Eintrittsfenster 3 angebracht. Allerdings finden sich hier keine Leiterbahnen auf dem Eintrittsfenster, sondern die Anschlußdrähte 12 für das Strahlungsbauelement 8 sind direkt nach außen an einen außen umlaufenden Kontaktring 14 oder entsprechende Kontaktflächen geführt.

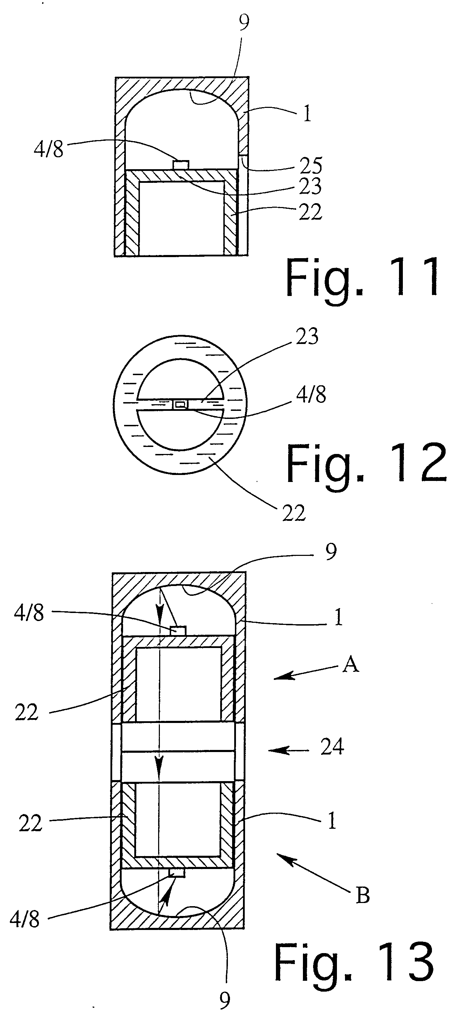

In Fig. 11 und 12 ist eine Alternative dargestellt, für die gilt, daß der Sensorträger 4 mit dem Strahlungsbauelement 8 auf einer vom Eintrittsfenster 3 separaten Halterung 22 angebracht ist, wobei die Halterung 22 nach konstruktiver Gestaltung und verwendeten Werkstoffen den Strahlungsverlauf durch das Eintrittsfenster 3 so wenig wie möglich behindert. Dabei es ist besonders zweckmäßig, daß die elektrischen Anschlußleitungen für das Strahlungsbauelement 8 als Leiterbahnen auf die Halterung 22 und/oder als dünne Anschlußdrähte ausgeführt sind und/oder von tragenden Strukturelementen der Halterung 22 selbst gebildet oder in diese integriert sind.

Bei dem in Fig. 11 dargestellten Ausführungsbeispiel gilt, daß die Halterung 22 als Hohlzylinder mit einem stirnseitig diagonal verlaufenden Tragsteg 23 für den Sensorträger 4 ausgeführt ist. Fig. 12 zeigt in Draufsicht was gemeint ist. Man erkennt, daß der Tragsteg 23 in der Tat den Strahlungsverlauf durch das Eintrittsfenster 3 in das Gehäuse 1 hinein so wenig wie möglich behindert. Auf dem Tragsteg 23 können die Anschlußdrähte für das Strahlungsbauelement 8 einfach seitlich nach außen geführt werden. Der Hohlzylinder, der hier die Halterung 22 bildet, besteht im dargestellten Ausführungsbeispiel aus Aluminium und ist als Spritzgußteil ausgeführt.

Weiter ist vorgesehen, daß das Gehäuse 1 mit dem Strahlungskollektorelement 9 als einseitig geschlossener Hohlzylinder ausgeführt ist, in den die als Hohlzylinder ausgeführte Halterung 22 eingepaßt ist. Das zeigt Fig. 11. Die größere Länge des Gehäuses 1 schirmt seitlich einfallende Mikrowellenstrahlung od. dgl. von dem thermoelektrischen Bauelement ab. In beiden Fällen gilt im übrigen, daß die Hohlzylinder im Querschnitt kreisförmig sind, das ist aber nicht zwingend. Bei entsprechend bemessener Wandstärke des Hohlzylinders hat dieser eine beachtliche Wärmekapazität und schafft somit eine homogene und relativ konstante Umgebungstemperatur für das Strahlungskollektorelement (9). Berücksichtigt man dann weiter, daß die Innenwandung des Hohlzylinders reflektrierend ist, so ergibt sich eine hohe Resistenz gegen temperaturbedingte Störspitzen.

In Fig. 11 ist seitlich angedeutet, daß das als Hohlzylinder ausgeführte Gehäuse 1 einen axialen Freischnitt zum Durchtritt von Anschlußleitungen aufweist. Das Gehäuse 1 wird also einfach auf den Hohlzylinder, der die Halterung 22 bildet, aufgesteckt.

Es liegt insgesamt natürlich auf der Hand, daß das Strahlungsbauelement 8 und die Anschlußleitungen für das Strahlungsbauelement 8 den Strahlungsverlauf durch das Eintrittsfenster 3 möglichst wenig stören sollen. Die Fig. 1 und 3 machen im Zusammenhang im übrigen deutlich, daß die hier gewählte Führung der Anschlußleitungen das erfindungsgemäße thermoelektrische Bauelement für einen bündigen Einbau besonders geeignet macht.

Im allgemeinen Teil der Beschreibung ist bei der Diskussion des Standes der Technik erläutert worden, wie das Strahlungsbauelement 8 durch mikromechanische Ätzung von Silizium hergestellt werden kann. Ein entsprechendes Material für das Eintrittsfenster 3, das für die erforderlichen Wellenlängen sehr durchlässig ist, ist ebenfalls Silizium. Das Gehäuse 1 wird im Ausführungsbeispiel gemäß Fig. 1 durch eine im Schnitt dargestellte Leiterplatte komplettiert, in der die Öffnung 2 vorgesehen ist.

Versuche habe ergeben, daß man mit einer sehr dünnen Leiterplatte oder, insbesondere, mit einer für entsprechende Leiterbahnen üblichen Kunststoffolie ebenfalls die Funktion eines Eintrittsfenster realisieren kann. Eine solche Kunststoffolie in einer Dicke bis zu 50 µ (beispielsweise Kaptonfolie oder PE-Folie) ist im interessierenden Wellenlängenbereich zwischen 5 µ und 15 µ hinreichend durchlässig. Damit kann die gesamte, dem Kollektorelement 9 gegenüberliegende Seite des Gehäuses 1 durch diese Kunststoffolie, die das Eintrittsfenster 3 bildet, gleichzeitig aber auch Leiterbahnen tragen kann, geschlossen werden. Das teure Silizium-Eintrittsfenster im Verbund mit der Leiterplatte mit Öffnung wird dadurch komplett ersetzt. Das ist herstellungstechnisch natürlich besonders zweckmäßig.

Das Gehäuse 1 besteht vorzugsweise aus Kunststoff, insbesondere aus dem im Bereich von Sensoren häufig eingesetzten ABS. Zur Bildung des Kollektorelements 9 ist das aus Kunststoff bestehende Gehäuse 1 zweckmäßiger Weise auf der Innenseite der Wandung mit einer reflektierenden Beschichtung versehen, insbesondere nämlich spiegelnd metallisiert. Dadurch ergibt sich auch für den Infrarotbereich ein höchstmöglicher Reflexionsgrad.

Für sich ist es bekannt, bei thermoelektrischen Bauelementen, insbesondere in der Ausführung mit einem Strahlungsempfängerelement, den interessierenden Wellenlängenbereich durch ein Filter für Strahlung bestimmter Wellenlängenbereiche einzuschränken. Dieses kann im Prinzip am Eintrittsfenster 3 vorgesehen sein. Dann allerdings ist die Fläche des Filters relativ groß. Fig. 3 zeigt daher ein besonders bevorzugtes Ausführungsbeispiel, bei dem zwar auch zwischen dem Eintrittsfenster 3 und der aktiven Oberfläche des Strahlungsbauelementes 8 ein Filter 15 für Strahlung bestimmter Wellenlängenbereiche angeordnet ist, bei dem aber das Filter 15 auf der aktiven Oberfläche des Strahlungsbauelementes 8 angeordnet ist. Damit wird die Fläche, die das Filter 15 einzunehmen hat, sehr klein, was die Verwendung teurer und hochwertiger Filtersysteme erlaubt. Gleichzeitig wird damit erreicht, daß das Eingangsfenster 3 aus einem für seine Zwecke optimal geeigneten Material ausgeführt sein kann, das nicht unbedingt als Substrat für Anbringung eines Filters geeignet sein muß.

An der Stelle, an der sich im zuvor erläuterten Ausführungsbeispiel das Filter 15 befindet, könnte zur Verbesserung der Fokussierung, also zur Ausblendung seitlicher Störstrahlung, auch eine Lochblende angeordnet sein. Diese kann z. B. als mikromechanisch erzeugte Komponente im Silizium-Substrat ausgeführt sein.

Eine entsprechende Ausgestaltung ist ohne weiteres auch für die Strahlungsbauelemente 8 im Ausführungsbeispiel gemäß Fig. 11 und Fig. 12 denkbar.
Das in Fig. 10 dargestellte Ausführungsbeispiel macht einerseits deutlich, wie das Kollektorelement 9 durch reflektierende Beschichtung der Innenseite der Wandung des Gehäuses 1 realisiert ist, macht andererseits deutlich, wie das Gehäuse 1 auf der dem Kollektorelement 9 gegenüberliegenden Seite durch eine Leiterplatte 20 komplett geschlossen sein kann. Hier gilt aber, daß durch die an sich geschlossene Seite - Leiterplatte 20 - ein Lichtwellenleiter 21 mit seinem Ende in das Gehäuse eintritt. Das Ende des Lichtwellenleiters 21, der durch die Öffnung 2 in der Leiterplatte 20, die ja Teil des Gehäuses 1 ist, eintritt, bildet das Eintrittsfenster 3. Das Strahlungsbauelement 8 ist nun nicht an, sondern nahe dem Eintrittsfenster 3 angeordnet, und zwar seitlich neben dem das Eintrittsfenster 3 bildenden Ende des Lichtwellenleiters 21. Im dargestellten Ausführungsbeispiel ist dabei weiter vorgesehen, daß das Kollektorelement 9 als Spiegel mit der Kontur eines Ellipsoids ausgeführt ist und daß das Ende des Lichtwellenelements 21 bzw. das Strahlungsbauelement 8 jeweils einem Brennpunkt des Ellipsoids zugeordnet ist.

Das optische Eintrittsfenster 3 in den Sensorinnenraum ist also auf die Stirnfläche des Lichtwellenleiters 21 reduziert. Auf der Leiterplatte 20 bzw. einer entsprechenden Kunststoffolie (Kaptonfolie), die die Anschlußleitungen vom Sensorinnenraum zu den äußeren Anstoßstellen trägt, kann die Positionierung des Strahlungsbauelements 8 erfolgen. Eine möglichst hohe Lichtausbeute am Strahlungsbauelement 8 ergibt sich dadurch, daß die Leiterplatte 20 bzw. die Kunststoffolie auf der Innenseite mit einer reflektierenden Beschichtung versehen ist, insbesondere spiegelnd metallisiert ist und ggf. über Trennlinien unterschiedliche Anschlußleitungen als flächige Bereiche realisiertsind.

Je nach Anforderungsprofil für das Bauelement kann eine möglichst gute thermische Kopplung mit der Umgebung oder eine effektive thermische Entkopplung von der Umgebung realisiert werden.

Nicht dargestellt ist in der Zeichnung, daß das Strahlungsbauelement 8 und/oder der Sensorträger 4 auf der der aktiven Oberfläche gegenüberliegenden Rückfläche im wesentlichen strahlungsdurchlässig ist oder mit einer für die interessierende Strahlung im wesentlichen undurchlässigen Sperrschicht versehen ist. Demgegenüber ist dargestellt eine besonders bevorzugte Ausführungsform, bei der es möglich ist, die Umgebungstemperatur bzw. die Temperatur des Sensorträgers 4 mit dem Strahlungsbauelement 8 separat zu messen, um im Ergebnis wirklich nur die "Nettoeinstrahlung" meßtechnisch zu erfassen. Dazu ist hier vorgesehen, daß das Strahlungsbauelement 8 und/oder der Sensorträger 4 auf der der aktiven Oberfläche gegenüberliegenden Rückfläche mit einem thermischen Dünnschicht-Sensorelement 16 zur Messung einer Umgebungstemperatur (Referenztemperatur) versehen ist.

Man erkennt in Fig. 4 das Dünnschicht-Sensorelement 16 bei hier abgenommenen Sensorträger 4 mit den dort nach außen geführten Leiterbahnen 11. Dieses Dünnschicht-Sensorelement 16 kann im dargestellten Ausführungsbeispiel gleichzeitig als zuvor erläuterte Sperrschicht für rückwärtige Strahlung dienen.

Das weiter oben schon erläuterte Problem der Fremdeinstrahlung auf das Strahlungsempfängerelement wird durch die Erfassung der Temperatur am Eintrittsfenster 3 durch das Dünnschicht-Sensorelement 16 dann komplett gelöst, da so tatsächlich die Nettoeinstrahlung ermittelbar ist. Ein Dünnschicht-Sensorelement 16 kann beispielsweise ein Ni-Widerstand sein, der unmittelbar in Form von Widerstands-Bahnen auf das Eintrittsfenster 3 aufgebracht ist.

Eine andere Analysemöglichkeit besteht darin, neben dem Strahlungsbauelement 8 ein weiteres, mit einem anderen Filter 15 versehenes Strahlungsbauelement 8 anzuordnen. Gegebenenfalls können auch mehrere weitere Strahlungsbauelemente 8 vorgesehen sein. Bei richtiger Wahl und Abstimmung der Filter 15 lassen sich beispielsweise die empfangenen Strahlungsspektren voneinander subtrahieren, um so den Wasserdampfgehalt in der Luft über die Prüfung der Wasserdampflinie im Subtraktionsspektrum festzustellen. Dieses Subtraktionsprinzip durch mehrere Strahlungsbauelemente 8 läßt sich natürlich für eine Vielzahl von Anwendungen modifizieren. Die Feststellung der Wasserdampflinie ist aber für den Bereich des Mikrowellen-Kochens besonders interessant.

Zuvor ist schon angedeutet worden, daß ein Strahlungsempfängerelement als Strahlungsbauelement 8 mit einer Absorptionsschicht versehen sein kann. Grundsätzlich möglich ist es auch, nur eine weniger stark absorbierende Abdeckschicht vorzusehen und demgegenüber die Dicken der Schichten der im Strahlungsempfängerelement selbst realisierten Schichtenfolge zur Bildung eines Interferenzsystems abzustimmen, so daß diese den Wellenlängen im interessierenden Wellenlängenbereich der zu erfassenden Strahlung entsprechen.

Die Fig. 6 und 7 zeigen Ausführungsbeispiele eines thermoelektrischen Bauelements, das ein als Strahlungsempfängerelement ausgeführtes Strahlungsbauelement 8 aufweist. Im Grundsatz entspricht der Aufbau, auch hinsichtlich der Filteranordnung in Fig. 7, dem Aufbau bei Einsatz eines Strahlungsempfängerelementes gemäß Fig. 1 und Fig. 3.

Nicht dargestellt ist eine Besonderheit, die bei einem Strahlungssenderelement von Bedeutung sein kann, nämlich daß auf der der aktiven Oberfläche gegenüberliegenden Rückfläche des als Strahlungssenderelement ausgeführten Strahlungsbauelementes 8 eine die Strahlung reflektierende Sperrschicht vorgesehen ist und daß das Strahlungsbauelement 8 mit räumlichen Durchbrechungen ausgeführt ist. Dadurch wird auch eine nach unten abgestrahlte Sendeleistung wiederum in die richtige Richtung hin reflektiert. Außerdem reduzieren die Durchbrechungen die Spannungen durch thermische Ausdehnung.

Für eine auf einer separaten Halterung erfolgende Anordnung eines Strahlungssenderelementes gelten im übrigen die gleichen Überlegungen wie zuvor für das Strahlungsempfängerelement erläutert.

Schließlich ist für die Ausführung des thermoelektrischen Bauelementes mit einem Strahlungssenderelement als Strahlungsbauelement 8 nicht dargestellt, daß oberhalb des Strahlungsbauelementes 8 im geringen Abstand ein weiteres Fenster montiert sein kann, mit dem die Konvektionsverhältnisse an der Oberfläche eingestellt werden können. Dieses Fenster kann als Transmissionsfilter ausgebildet sein. Es ergibt sich eine Art Deckelverschluß für das Strahlungsbauelement 8.

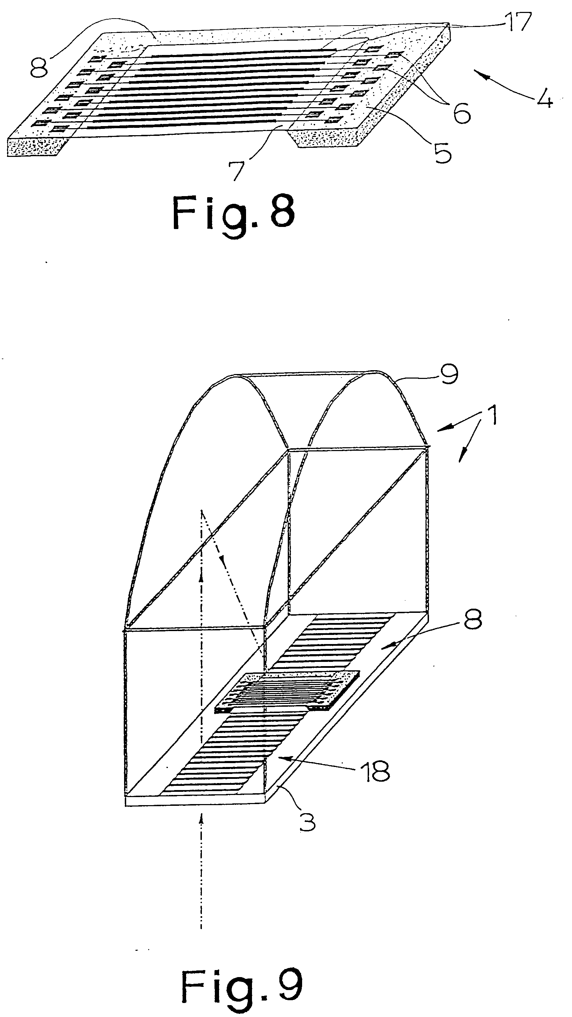

Im Grundsatz unabhängig von einem Strahlungs-Kollektorelement 9 ist die in den Fig. 8 und 9 dargestellte Ausführung eines erfindungsgemäßen thermoelektrischen Bauelementes, die jedoch in Verbindung mit den Merkmalen des kennzeichnenden Teils eines oder mehrerer der vorhergehenden Ansprüche besonders zweckmäßig eingesetzt werden kann.

Hier gilt, daß das Strahlungsbauelement 8 mindestens zwei, vorzugsweise mehrere voneinander unabhängige Strahlungsempfänger 17 aufweist, deren aktive Oberflächen in einer Ebene nebeneinander angeordnet sind. Das erkennt man in Fig. 8 sehr gut, dort befinden sich insgesamt 12 solcher Strahlungsempfänger 17 streifenartig nebeneinander in einem Strahlungsbauelement 8. Auch hier ist die übliche Konstruktion mit Rahmen 5 und Trägermembran 7 im übrigen realisiert.

Mit dieser Anordnung einer Mehrzahl von Strahlungsempfängern 17 in einem Strahlungsbauelement 8 läßt sich zunächst eine räumliche Analyse der einfallenden Strahlung vornehmen, insbesondere wenn man hier das weiter oben ausführlich erläuterte Strahlungs-Kollektorelement 9 vorsieht. Eine derartige Konstruktion ist in Fig. 9 dargestellt.

Eine relativ einfache spektrometrische Anordnung erhält man dadurch, daß die unterschiedlichen Strahlungsempfänger 17 auf unterschiedliche Strahlungsfrequenzen (Wellenlängen) abgestimmt sind und dazu, insbesondere, mit unterschiedlichen Interferenzschichtsystemen ausgeführt sind. Es darf hier an das in Verbindung mit Anspruch 13 erläuterte System angeschlossen werden.

Das in Fig. 9 dargestellte Ausführungsbeispiel zeigt nun noch eine weitere Ausführungsform, die dadurch gekennzeichnet ist, daß am oder nahe an dem Eintrittsfenster 3 im Strahlungsweg ein die Strahlung wellenlängenabhängig beugendes Eingangsfilter 18, vorzugsweise ausgeführt als Beugungsgitter vorgesehen ist. Das Beugungsgitter als Eingangsfilter 18 ist hier unmittelbar auf das Eingangsfenster 3 aufgebracht.

Man erkennt hier im übrigen, daß das Kollektorelement 9 als zylindrischer Spiegel ausgeführt ist. Dies entspricht der langgestreckten Ausführung des Eingangsfilters 18, die für die Gestaltung des Kollektormotors 9 eine Vorzugsrichtung vorgibt.

Für den Anschluß und die Kontaktierung der verschiedenen Strahlungsempfänger 17 im in den Fig. 8 und 9 dargestellten Ausführungsbeispiel gelten im übrigen die weiter oben gemachten Ausführungen zu den anderen Ausführungsbeispielen entsprechend. Eine Besonderheit für das in Fig. 8 dargestellte thermoelektrische Bauelement ist jedoch, daß die einzelnen streifenartigen Strahlungsempfänger 17 durch Längsschlitze in einer ansonsten durchgehenden Trägermembran 7 voneinander entkoppelt sind. Es handelt sich primär um eine thermische Entkopplung, so daß eine Quer-Wärmeleitung zwischen den Strahlungsempfängern 17 nicht erfolgt (Übersprechdämpfung).

Handelt es sich bei der Trägermembran 7 um ein für die Strahlung im interessierenden Wellenlängenbereich durchlässiges Material und/oder liegen die Längsschlitze mit hinreichender Breite vor, so kann man auch eine Variante realisieren, bei der die Reihe von streifenartigen Strahlungsempfängern 17 etwa die Fläche des Eintrittsfensters 3 abdeckt, der Strahlungsweg durch die Reihe von streifenartigen Strahlungsempfängern 17 hindurch erfolgt und die Reihe von streifenartigen Strahlungsempfängern 17 selbst die Funktion eines Beugungsgitters hat. Das ist in der Zeichnung allerdings nicht weiter dargestellt.

Ganz generell gilt schließlich, daß durch Beschichtung und Materialauswahl des Eintrittsfensters 3 eine Filterwirkung für nicht gewünschte Wellenlängen realisiert werden kann und daß im übrigen für die Ausgrenzung störender Einstrahlung und die Ermittlung der Netto-Einstrahlung die weiter oben schon erläuterten Maßnahmen getroffen werden können.

Fig. 13 zeigt schließlich eine besondere Nutzung zweier gekoppelter thermoelektrischer Bauelemente nach Art eines "Optokopplers". Hier wird eine Meßstrecke 24 zwischen zwei gegeneinander gerichtete thermoelektrische Bauelemente realisiert. Durch die Meßstrecke 24 wird ein Gasstrom geleitet (beispielsweise Luft mit CO₂). Vom oberen thermoelektrischen Bauelement mit einem als Strahlungssenderelement ausgeführten Strahlungsbauelement 8 ausgehende Strahlung wird vom Strahlungsbauelement 8 als Strahlungsempfängerelement im unteren thermoelektrischen Bauelement empfangen. Die Absorption im Gasstrom ist ein Maß für die Zusammensetzung des Gasstroms.

Ein besonderer Anwendungsfall erfindungsgemäßer thermoelektrischer Bauelemente ist die Temperaturmessung im Mikrowellenherd sowie die Temperatur und Wasserdampfmessung (Feuchtemessung) bei Wäschetrocknern.

## Patentansprüche

1. Thermoelektrisches Bauelement, insbesondere für infrarote und sichtbare Strahlung, mit einem, vorzugsweise hermetisch geschlossenen und einen Sensorinnenraum mit einer definierten Gasfüllung bildenden, Gehäuse (1) mit einer Öffnung (2), die vorzugsweise durch ein für die Strahlung durchlässiges Eintrittsfenster (3) abgedeckt ist, mit einem im Gehäuse (1) angeordneten Sensorträger (4) mit einem darauf angeordneten Strahlungsbauelement (8), wobei das Strahlungsbauelement (8) eine aktive Oberfläche aufweist, und mit aus dem Gehäuse (1) herausgeführten elektrischen Anschlußleitungen (11, 12) für das Strahlungsbauelement (8), **dadurch gekennzeichnet**, daß im Gehäuse (1) mit Abstand vom Eintrittsfenster (3) bzw. von der Öffnung (2) und vorzugsweise mittig dazu ausgerichtet ein Strahlungs-Kollektorelement (9) in Form eines Spiegels (oder eines Spiegelsystems) angeordnet ist oder die Innenseite der Wandung des Gehäuses (1) ein solches Kollektorelement (9) bildet, daß die aktive Oberfläche des Strahlungsbauelementes (8) vom Eintrittsfenster (3) bzw. von der Öffnung (2) weg zum Kollektorelement (9) gerichtet ist.

2. Thermoelektrisches Bauelement nach dem vorhergehenden Anspruch, dadurch gekennzeichnet, daß das Strahlungsbauelement (8) nahe an dem oder unmittelbar an dem Eintrittsfenster (3) bzw. der Öffnung (2) angeordnet ist.

3. Thermoelektrisches Bauelement nach einem der vorhergehenden Ansprüche, dadurch gekennzeichnet, daß das Strahlungsbauelement (8) als Strahlungsempfängerelement ausgeführt ist und das Kollektorelement (9) die in einem bestimmten Öffnungswinkelbereich eintretende Strahlung auf die aktive Oberfläche des Strahlungsbauelementes (8) konzentriert.

4. Thermoelektrisches Bauelement nach einem der vorhergehenden Ansprüche, dadurch gekennzeichnet, daß das Strahlungsbauelement (8) als Strahlungssenderelement ausgeführt ist und das Kollektorelement (9) die von der aktiven Oberfläche des Strahlungsbauelementes (8) abgestrahlte Strahlung zum Eintrittsfenster (3) bzw. zur Öffnung (2) hin umlenkt, so daß diese in einem bestimmten Öffnungswinkelbereich austritt.

5. Thermoelektrisches Bauelement nach einem der vorhergehenden Ansprüche, dadurch gekennzeichnet, daß die aktive Oberfläche des Strahlungsbauelementes (8) mittig zum Kollektorelement (9) ausgerichtet ist.

6. Thermoelektrisches Bauelement nach einem der vorhergehenden Ansprüche, dadurch gekennzeichnet, daß das Kollektorelement (9) als sphärischer Spiegel, vorzugsweise mit der Kontur eines Kegelschnittes, insbesondere als Parabolspiegel, ausgeführt ist und das Strahlungsbauelement (8) im wesentlichen in der Brennebene des Spiegels liegt.

7. Thermoelektrisches Bauelement nach einem der vorhergehenden Ansprüche, dadurch gekennzeichnet, daß sich zwischen dem Kollektorelement (9) und dem Eintrittsfenster (3) bzw. der Öffnung (2) ein gerader Abschnitt der Wandung des Gehäuses (1) befindet.

8. Thermoelektrisches Bauelement nach einem der vorhergehenden Ansprüche, dadurch gekennzeichnet, daß das Kollektorelement (9) relativ zum Strahlungsbauelement (8), insbesondere in Richtung des Strahlungsverlaufs am Eintrittsfenster (3), verstellbar ist.

9. Thermoelektrisches Bauelement nach einem der vorhergehenden Ansprüche, dadurch gekennzeichnet, daß der Sensorträger (4) mit dem Strahlungsbauelement (8) auf dem Eintrittsfenster (3) angebracht ist und die elektrischen Anschlußleitungen für das Strahlungsbauelement (8) als Leiterbahnen (11) auf dem Eintrittsfenster (3) und/oder als dünne Anschlußdrähte (12) (Bonddrähte) ausgeführt sind.

10. Thermoelektrisches Bauelement nach einem der vorhergehenden Ansprüche, dadurch gekennzeichnet, daß der Sensorträger (4) mit dem Strahlungsbauelement (8) auf einer, vom Eintrittsfenster (3) separaten, Halterung (22) angebracht ist und daß die Halterung (22) nach konstruktiver Gestaltung und verwendeten Werkstoffen den Strahlungsverlauf durch das Eintrittsfenster (3) bzw. die Öffnung (2) so wenig wie möglich behindert.

11. Thermoelektrisches Bauelement nach einem der vorhergehenden Ansprüche, dadurch gekennzeichnet, daß die Halterung (22) als vorzugsweise aus Aluminium bestehender, vorzugsweise im Spritzgußverfahren hergestellter Hohlzylinder mit einem stirnseitig diagonal verlaufenden, schmalen Tragsteg (23) für den Sensorträger (4) ausgeführt ist.

12. Thermoelektrisches Bauelement nach einem der vorhergehenden Ansprüche, dadurch gekennzeichnet, daß das Gehäuse (1) mit dem Strahlungskollektorelement (9) als einseitig geschlossener Hohlzylinder ausgeführt ist, in den die als Hohlzylinder ausgeführte Halterung (22) eingepaßt ist.

13. Thermoelektrisches Bauelement nach einem der vorhergehenden Ansprüche, dadurch gekennzeichnet, daß der Hohlzylinder bzw. die Hohlzylinder im Querschnitt kreisförmig ist bzw. sind.

14. Thermoelektrisches Bauelement nach einem der vorhergehenden Ansprüche, dadurch gekennzeichnet, daß das als Hohlzylinder ausgeführte Gehäuse (1) einen axialen Freischnitt (25) zum Durchtritt von Anschlußleitungen aufweist.

15. Thermoelektrisches Bauelement nach einem der vorhergehenden Ansprüche, dadurch gekennzeichnet, daß die elektrischen Anschlußleitungen für das Strahlungsbauelement (8) als Leiterbahnen auf der Halterung und/oder als dünne Anschlußdrähte ausgeführt sind und/oder von tragenden Strukturelementen der Halterung selbst gebildet oder in diese integriert sind.

16. Thermoelektrisches Bauelement nach einem der vorhergehenden Ansprüche, dadurch gekennzeichnet, daß das Eintrittsfenster (3) die gesamte, dem Kollektorelement (9) gegenüberliegende Seite des Gehäuses (1) bildet.

17. Thermoelektrisches Bauelement nach einem der vorhergehenden Ansprüche, dadurch gekennzeichnet, daß das Eintrittsfenster (3) als Leiterplatte oder als mit Leiterbahnen (11) versehene Kunststoffolie ausgeführt ist.

18. Thermoelektrisches Bauelement nach einem der vorhergehenden Ansprüche, dadurch gekennzeichnet, daß das Gehäuse (1) aus Kunststoff, insbesondere ABS-Kunststoff besteht und, insbesondere, die Verspiegelung des Kollektorelementes (9) durch Metalliesieren des Kunststoffes realisiert ist.

19. Thermoelektrisches Bauelement nach einem der vorhergehenden Ansprüche, dadurch gekennzeichnet, daß das Gehäuse (1) auf der Innenseite der Wandung mit einer reflektierenden Beschichtung versehen, insbesondere spiegelnd metallisiert ist.

20. Thermoelektrisches Bauelement nach einem der vorhergehenden Ansprüche, dadurch gekennzeichnet, daß zwischen dem Eintrittsfenster (3) bzw. der Öffnung (2) und der aktiven Oberfläche des Strahlungsbauelementes (8) ein Filter (15) für Strahlung bestimmter Wellenlängenbereiche angeordnet ist.

21. Thermoelektrisches Bauelement nach einem der vorhergehenden Ansprüche, dadurch gekennzeichnet, daß das Filter (15) auf der aktiven Oberfläche des Strahlungsbauelementes (8) angeordnet ist.

22. Thermoelektrisches Bauelement nach einem der vorhergehenden Ansprüche, dadurch gekennzeichnet, daß zwischen dem Eintrittsfenster (3) bzw. der Öffnung (2) und der aktiven Oberfläche, vorzugsweise auf der aktiven Oberfläche des Strahlungsbauelementes (8) eine Lochblende angeordnet ist.

23. Thermoelektrisches Bauelement nach einem der vorhergehenden Ansprüche, dadurch gekennzeichnet, daß das Gehäuse (1) auf der dem Kollektorelement (9) gegenüberliegenden Seite an sich geschlossen ist, vorzugsweise durch eine Leiterplatte (20) oder eine Kunststoffolie, daß durch die an sich geschlossene Seite ein Lichtwellenleiter (21) mit seinem Ende in das Gehäuse (1) eintritt und das Ende des Lichtwellenleiters (21) das Eintrittsfenster (3) bildet und daß das Strahlungsbauelement (8) seitlich neben dem Ende des Lichtwellenleiters (21) angeordnet ist.

24. Thermoelektrisches Bauelement nach einem der vorhergehenden Ansprüche, dadurch gekennzeichnet, daß das Kollektorelement (9) als Spiegel mit der Kontur eines Ellipsoids ausgeführt ist und daß das Ende des Lichtwellenleiters (21) bzw. das Strahlungsbauelement (8) jeweils einem Brennpunkt des Ellipsoids zugeordnet ist.

25. Thermoelektrisches Bauelement nach einem der vorhergehenden Ansprüche, dadurch gekennzeichnet, daß die Leiterplatte (20) bzw. die Kunststoffolie auf der Innenseite mit einer reflektierenden Beschichtung versehen, insbesondere spiegelnd metallisiert ist und ggf. über Trennlinien unterschiedliche Anschlußleitungen als flächige Bereiche realisiert sind.

26. Thermoelektrisches Bauelement nach einem der vorhergehenden Ansprüche, dadurch gekennzeichnet, daß das Strahlungsbauelement (8) und/oder der Sensorträger (4) auf der der aktiven Oberfläche gegenüberliegenden Rückfläche im wesentlichen strahlungsundurchlässig ist oder mit einer für die interessierende Strahlung im wesentlichen undurchlässigen Sperrschicht versehen ist.

27. Thermoelektrisches Bauelement nach einem der vorhergehenden Ansprüche, dadurch gekennzeichnet, daß das Strahlungsbauelement (8) und/oder der Sensorträger (4) auf der der aktiven Oberfläche gegenüberliegenden Rückfläche mit einem thermischen Dünnschicht-Sensorelement (16) zur Messung einer Referenztemperatur (Chiptemperatur, Umgebungstemperatur, etc.) versehen ist.

28. Thermoelektrisches Bauelement nach einem der vorhergehenden Ansprüche, dadurch gekennzeichnet, daß das als Strahlungsempfängerelement ausgeführte Strahlungsbauelement (8) mit Schichtdicken in der realisierten Schichtfolge ausgeführt ist, die zur Bildung eines Interferenzsystems für Wellenlängen interessierenden Wellenlängenbereich der Strahlung führen.

29. Thermoelektrisches Bauelement nach einem der vorhergehenden Ansprüche, dadurch gekennzeichnet, daß auf der der aktiven Oberfläche gegenüberliegenden Rückfläche des als Strahlungssenderelement ausgeführten Strahlungsbauelementes (8) eine die Strahlung reflektierende Sperrschicht vorgesehen ist und daß das Strahlungsbauelement (8) mit der räumlichen Durchbrechungen ausgeführt ist.

30. Thermoelektrisches Bauelement nach dem Oberbegriff von Anspruch 1 und, vorzugsweise, dem kennzeichnenden Teil von Anspruch 1 und ggf. dem kennzeichnenden Teil eines oder mehrerer der vorhergehenden Ansprüche, wobei das Strahlungsbauelement (8) als Strahlungsempfängerelement ausgeführt ist, dadurch gekennzeichnet, daß das Strahlungsbauelement (8) mindestens zwei, vorzugsweise mehrere voneinander unabhängige Strahlungsempfänger (17) aufweist, deren aktive Oberflächen, vorzugsweise in einer Ebene nebeneinander angeordnet sind.

31. Thermoelektrisches Bauelement nach Anspruch 30, dadurch gekennzeichnet, daß die unterschiedlichen Strahlungsempfänger (17) auf unterschiedliche Strahlungsfrequenz (Wellenlängen) abgestimmt sind und dazu, insbesondere, mit unterschiedlichen Interferenzschichtsystemen ausgeführt sind.

32. Thermoelektrisches Bauelement nach Anspruch 30 oder 31, dadurch gekennzeichnet, daß am oder nahe an dem Eintrittsfenster (3) im Strahlungsweg ein die Strahlung wellenlängenabhängig beugendes Eingangsfilter (18), vorzugsweise ausgeführt als Beugungsgitter, vorgesehen ist.

33. Thermoelektrisches Bauelement nach einem der Ansprüche 30 bis 32, dadurch gekennzeichnet, daß das Strahlungsbauelement (8) eine Reihe von mehreren streifenartigen, nebeneinander angeordneten Strahlungsempfängern (17) aufweist.

34. Thermoelektrisches Bauelement nach Anspruch 33, dadurch gekennzeichnet, daß das Kollektorelement (9) als zylindrischer Spiegel ausgeführt sind.

35. Thermoelektrisches Bauelement nach Anspruch 33 oder 34, dadurch gekennzeichnet, daß die einzelnen streifenartigen Strahlungsempfänger (17) durch Längsschlitze in einer ansonsten durchgehenden Trägermembran (7) voneinander entkoppelt sind.

36. Thermoelektrisches Bauelement nach einem der Ansprüche 33 bis 35, dadurch gekennzeichnet, daß die Reihe von streifenartigen Strahlungsempfängern (17) etwa die Fläche des Eintrittsfensters (3) abdeckt, der Strahlungsweg durch die Reihe von streifenartigen Strahlungsempfängern (17) hindurch erfolgt und die Reihe von streifenartigen Strahlungsempfängern (17) selbst die Funktion eines Beugungsgitters hat.

37. Thermoelektrisches Bauelement nach einem der vorhergehenden Ansprüche, dadurch gekennzeichnet, daß neben dem Strahlungsbauelement (8) ein weiteres, mit einem anderen Filter (15) versehenes Strahlungsbauelement (8) angeordnet ist und so durch Wahl entsprechender Filter (15) modifizierte Messungen, insbesondere Subtraktionsmessungen, ausgeführt werden können.

38. Thermoelektrisches Bauelement nach einem der vorhergehenden Ansprüche, dadurch gekennzeichnet, daß zwei thermoelektrische Bauelemente (A) und (B) gegeneinander gerichtet angeordnet sind und das eine thermoelektrische Bauelement als Strahlungsbauelement (8) ein Strahlungssenderelement und das andere thermoelektrische Bauelement als Strahlungsbauelement (8) ein Strahlungsempfängerelement aufweist, die nach Art eines "Optokopplers" strahlungsmäßig miteinander gekoppelt sind, und daß zwischen den Eintrittsseiten der beiden Gehäuse (1) der beiden thermoelektrischen Bauelemente eine Meßstrecke (24), vorzugsweise zur Durchströmung mittels eines Gasstromes, ausgebildet ist.

39. Thermoelektrisches Bauelement nach einem der vorhergehenden Ansprüche, dadurch gekennzeichnet, daß in das Gehäuse (1) eine Auswerteelektronik, insbesondere auf einem Chip bzw. dem das Strahlungsbauelement (8) aufweisenden Chip integriert ist.
